# EUROPEAN PATENT APPLICATION

(11) **EP 4 580 369 A1**
(43) Date of publication of application: **02.07.2025**
(21) Application number: 24223461.5
(22) Date of filing: 27.12.2024
(51) Int. Cl.: H10K 59/126, H10K 59/40, H10K 59/80

(54) **DISPLAY DEVICE AND METHOD OF MANUFACTURING THE SAME**

(30) Priority: 29.12.2023 KR 20230197213
(71) Applicant: Samsung Display Co., Ltd., Yongin-si, Gyeonggi-do 17113 (KR)
(72) Inventor: Kim, Jungwook, 17113 Yongin-si, Gyeonggi-do (KR); Kim, Moonkon, 17113 Yongin-si, Gyeonggi-do (KR); Nam, Kiyol, 17113 Yongin-si, Gyeonggi-do (KR); Mun, Eunjoong, 17113 Yongin-si, Gyeonggi-do (KR); Park, Kyounghee, 17113 Yongin-si, Gyeonggi-do (KR); Hwang, Hyeondeuk, 17113 Yongin-si, Gyeonggi-do (KR)
(74) Representative: Gulde & Partner

(57) **Abstract**

A display device includes a cover panel, a display panel arranged on the cover panel, a polarizing layer arranged on the display panel, a cover glass arranged on the polarizing layer, and a conductive polymer layer continuously arranged along a lower surface of the cover glass, a side surface of the polarizing layer, upper and side surfaces of the display panel, and lower and side surfaces of the cover panel, wherein a thickness of the conductive polymer layer arranged on the lower surface of the cover panel is about 50 µm or less.

## Description

### BACKGROUND

### 1. Technical Field

One or more embodiments relate to a display device and a method of manufacturing the same.

### 2. Description of the Related Art

Display devices visually display data. Display devices may provide an image by using light-emitting diodes. The use of display devices has diversified, and various designs for improving the quality of display devices have been attempted.

### SUMMARY

One or more embodiments include a display device and a method of manufacturing the same.

Additional aspects will be set forth in part in the description which follows and, in part, will be apparent from the description, or may be learned by practice of the presented embodiments of the disclosure.

According to one or more embodiments, a display device includes a cover panel, a display panel arranged on the cover panel, a polarizing layer arranged on the display panel, a cover glass arranged on the polarizing layer, and a conductive layer continuously arranged along a lower surface of the cover glass, a side surface of the polarizing layer, upper and side surfaces of the display panel, and lower and side surfaces of the cover panel, wherein a thickness of the conductive layer arranged on the lower surface of the cover panel is about 50 µm or less. The thickness may be below 40 µm or less, preferably below 40 µm or less, more preferably 30 µm or less, even below 20 µm or less. The thickness may be 6.9 µm to about 8.7 µm

According to an embodiment, an end of the cover glass, an end of the polarizing layer, and ends of the display panel and the cover panel may not be aligned with one another.

According to an embodiment, a thickness of the conductive layer arranged on the lower surface of the cover glass may be about 50 µm or less.

According to an embodiment, a minimum length of the conductive layer arranged along the edge of the display device may be about 20 mm or greater. The length may be 30 mm or greater, preferably 40 mm or greater, more preferably 50 mm or greater.

According to an embodiment, the conductive layer may include poly(3,4-ethylenedioxythiophene) polystyrene sulfonate (PEDOT:PSS). The conductive layer may further include a solvent including de-ionized water or alcohol.

According to an embodiment, the display device may further include an adhesive layer arranged between the polarizing layer and the cover glass.

According to an embodiment, the conductive layer may be further arranged on a side surface of the adhesive layer.

According to an embodiment, the display device may further include a set structure arranged under the cover glass and the cover panel.

According to one or more embodiments, a method of manufacturing a display device includes arranging a material for forming a conductive layer on a cover glass, a polarizing layer, a display panel, and a cover panel, and forming a conductive layer by naturally drying (e.g., by allowing solvents to evaporate) the material for forming a conductive layer.

According to an embodiment, the conductive layer may be continuously arranged along an upper surface of the cover glass, a side surface of the polarizing layer, lower and side surfaces of the display panel, and upper and side surfaces of the cover panel.

According to an embodiment, the material for forming a conductive layer may include a conductive polymer and a solvent.

According to an embodiment, when the material for forming a conductive polymer layer is dried, the solvent included in the material for forming a conductive polymer layer may evaporate to form the conductive polymer layer.

According to an embodiment, the conductive polymer may include poly(3,4-ethylenedioxythiophene) polystyrene sulfonate (PEDOT:PSS).

According to an embodiment, the solvent may include de-ionized water or alcohol.

According to an embodiment, a viscosity of the material for forming a conductive polymer layer may be at least about 100 cP.s but not more than about 500 cP.s.

According to an embodiment, a content of the conductive polymer in the material for forming a conductive polymer layer may be at least about 3 % but not more than about 20 %.

According to an embodiment, a thickness of the conductive polymer layer arranged on an upper surface of the cover panel may be about 50 µm or less.

According to an embodiment, a thickness of the conductive polymer layer arranged on an upper surface of the cover glass may be about 50 µm or less.

According to an embodiment, a minimum length of the conductive polymer layer arranged on at least a part of a side portion of the display device may be about 20 mm or greater.

According to an embodiment, the method may further include arranging a set structure on the cover panel and the cover glass.

According to an embodiment, a surface tension of the material for forming a conductive polymer layer may be at least about 25 mN/m but not more than about 35 mN/m.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view of a display device;
FIG. 2 is a schematic cross-sectional view of a side portion of a display device on which a conductive polymer layer is disposed;
FIGS. 3A and 3B shows schematic pictures illustrating thicknesses of a conductive polymer layer disposed on upper surfaces of a cover glass and a cover panel;
FIGS. 4 to 6 schematically show a method of manufacturing a display device;
FIG. 7 is a schematic diagram of an equivalent circuit of a pixel; and
FIG. 8 is a schematic cross-sectional view of a display device.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects of the description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the description allows for various changes and numerous embodiments, certain embodiments will be illustrated in the drawings and described in the written description. Effects and features of one or more embodiments and methods of accomplishing the same will become apparent from the following detailed description of the one or more embodiments, taken in conjunction with the accompanying drawings. However, the embodiments may have different forms and should not be construed as being limited to the descriptions set forth herein.

One or more embodiments will be described below in more detail with reference to the accompanying drawings. Those elements that are the same or are in correspondence with each other are rendered the same reference numeral regardless of the figure number, and redundant descriptions thereof are omitted.

While such terms as "first" and "second" may be used to describe various elements, such elements must not be limited to the above terms. The above terms are used only to distinguish one element from another.

The singular forms, such as "a" and "an," as used herein are intended to include the plural forms as well unless the context clearly indicates otherwise.

It will be understood that the terms "include," "comprise," "have" and their variations as used herein specify the presence of stated features or elements but do not preclude the addition of one or more other features or elements.

It will be further understood that, when a layer, region, or element is referred to as being on another layer, region, or element, it may be directly or indirectly on the other layer, region, or element. That is, for example, intervening layers, regions, or elements may be present.

Sizes of elements in the drawings may be exaggerated or reduced for convenience of explanation. For example, since sizes and thicknesses of elements in the drawings are arbitrarily illustrated for convenience of explanation, the following embodiments are not limited thereto.

When an embodiment may be implemented differently, a certain process order may be performed differently from the described order. For example, two consecutively described processes may be performed substantially at the same time or performed in an order opposite to the described order.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

It will be further understood that, when layers, regions, or elements are referred to as being connected to each other, they may be directly connected to each other and/or may be indirectly connected to each other with intervening layers, regions, or elements therebetween. For example, when layers, regions, or elements are referred to as being electrically connected to each other, they may be directly electrically connected to each other and/or may be indirectly electrically connected to each other with intervening layers, regions, or elements therebetween.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

The term "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

For ease of explanation herein, to describe the relationship of one element or feature to another as illustrated in the drawings, spatially relative terms such as "below", "above", "lower", "upper", "downward", etc. may be used. Spatially relative terms may be basically defined as disclosed in the accompanied drawings, but not limited thereto. For example, the +z direction refers to the term "upper".

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

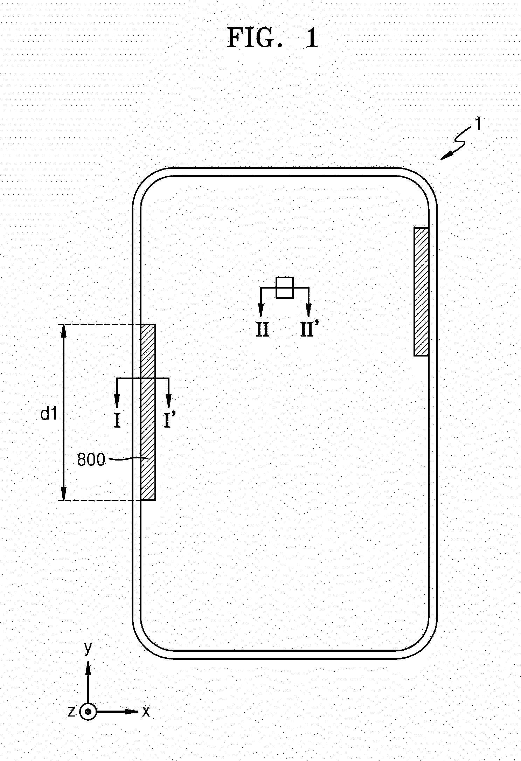

FIG. 1 is a schematic plan view of a display device 1.

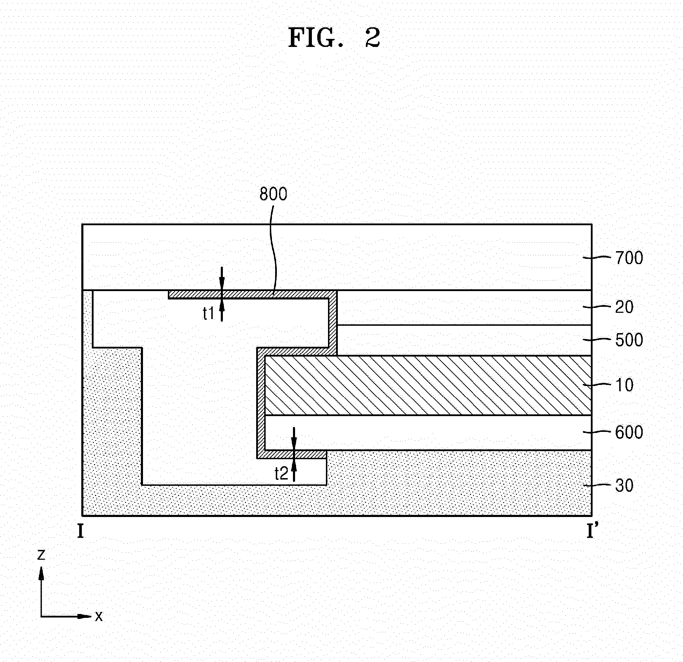

Referring to FIG. 1, a conductive layer or conductive polymer layer 800 (hereinafter "conductive polymer layer") may be arranged at an edge of the display device 1. In other words, the conductive polymer layer 800 may be disposed on at least a part of a side portion of the display device 1. In a case where the conductive polymer layer 800 is not disposed on at least a part of a side portion of the display device 1, in case that static electricity is generated in a cover glass 700 (refer to FIG. 2) by, for example, a person's touch, electrons may be accumulated between a display panel 10 (refer to FIG. 2) and a cover panel 600 (refer to FIG. 2), and thus, the quality and reliability of the display device 1 may degrade. In a case where the conductive polymer layer 800 is disposed on at least a part of a side portion of the display device 1, in case that static electricity is generated in the cover glass 700 by, for example, a person's touch, electrons may move along the conductive polymer layer 800, and because electrons are not accumulated between the display panel 10 and the cover panel 600, the quality and reliability of the display device 1 may be improved.

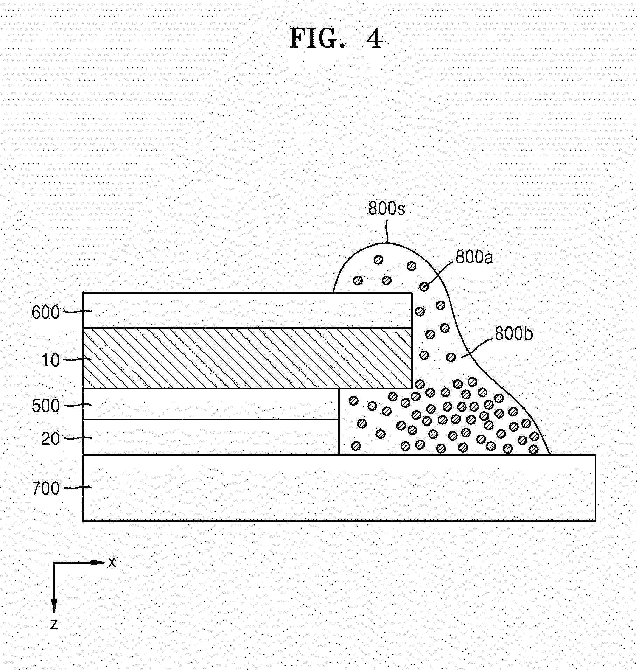

A minimum length d1 of the conductive polymer layer 800 disposed on at least a part of a side portion of the display device 1 may be about 20 mm or greater. In a process of manufacturing the display device 1, a viscosity of a material 800s (refer to FIG. 4) for forming a conductive polymer layer may be at least about 100 cP.s but not more than about 500 cP.s, and thus, spreadability of the material 800s for forming a conductive polymer layer disposed on the cover glass 700 and the cover panel 600 may be controlled, and accordingly, the minimum length d1 of the conductive polymer layer 800 disposed on at least a part of a side portion of the display device 1 may be about 20 mm or greater.

FIG. 2 is a schematic cross-sectional view of a side portion of a display device on which a conductive polymer layer is disposed. More specifically, FIG. 2 is a schematic cross-sectional view of at least a part of a side portion of the display device 1 of FIG. 1, taken along a line I-I' of FIG. 1.

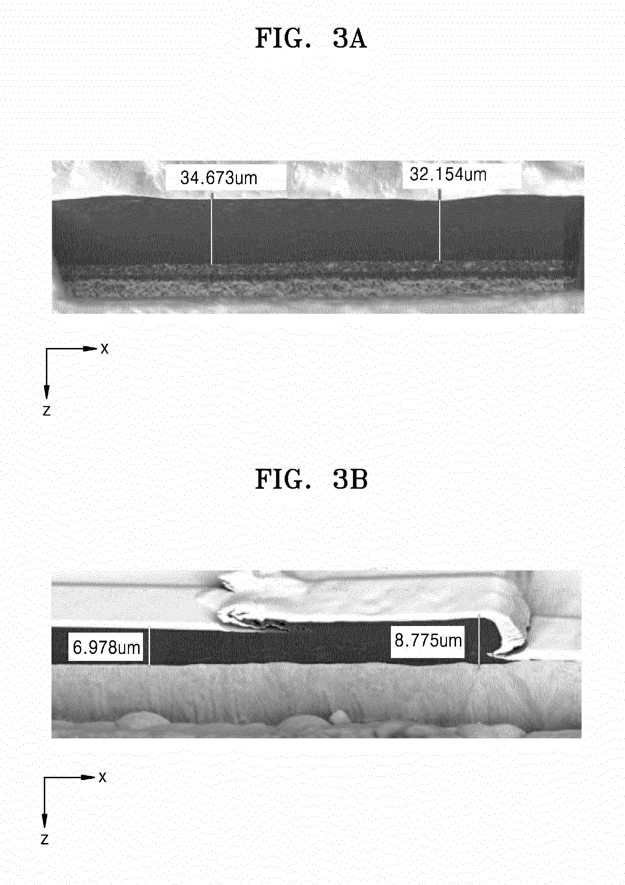

FIGS. 3A and 3B show schematic pictures illustrating thicknesses of a conductive polymer layer disposed on upper surfaces of a cover glass and a cover panel. More specifically, FIG. 3A shows a thickness of the conductive polymer layer 800 disposed on an upper surface of the cover glass 700, and FIG. 3B shows a thickness of the conductive polymer layer 800 disposed on an upper surface of the cover panel 600. FIGS. 3A and 3B are different at least in the top and bottom directions from the cross-sectional view of FIG. 2 showing at least a part of a side portion of the display device 1. More specifically, the top of FIG. 2 and the bottom of FIG. 3 represent a direction z, and the bottom of FIG. 2 and the top of FIG. 3 represent a direction -z.

Referring to FIG. 2, a polarizing layer 500 may be disposed on the display panel 10. The cover glass 700 may be disposed over the polarizing layer 500. An adhesive layer 20 may be disposed between the cover glass 700 and the polarizing layer 500. The cover panel 600 may be disposed under the display panel 10. A set structure 30 may be disposed under the cover glass 700 and the cover panel 600. An end of the cover glass 700, an end of the polarizing layer 500, and ends of the display panel 10 and the cover panel 600 may not be aligned with one another.

The conductive polymer layer 800 may be continuously arranged along a lower surface of the cover glass 700, a side surface of the polarizing layer 500, upper and side surfaces of the display panel 10, and side and lower surfaces of the cover panel 600. In case that the display device 1 further includes the adhesive layer 20 disposed between the polarizing layer 500 and the cover glass 700, the conductive polymer layer 800 may be continuously arranged along a lower surface of the cover glass 700, side surfaces of the polarizing layer 500 and the adhesive layer 20, upper and side surfaces of the display panel 10, and side and lower surfaces of the cover panel 600. The conductive polymer layer 800 may include, for example, poly(3,4-ethylenedioxythiophene) polystyrene sulfonate (PEDOT:PSS). A thickness t1 of the conductive polymer layer 800 disposed on the lower surface of the cover glass 700 may be about 50 µm or less. A thickness t2 of the conductive polymer layer 800 disposed on the lower surface of the cover panel 600 may be about 50 µm or less.

Referring to FIGS. 3A and 3B, the direction z in FIG. 3 is different from that in FIG. 2, and accordingly, in FIGS. 3A and 3B showing the cross-sections of a display device, the conductive polymer layer 800 may be disposed on upper surfaces of the cover glass 700 and the cover panel 600. More specifically, referring to FIG. 3S, a thickness of the conductive polymer layer 800 disposed on an upper surface of the cover glass 700 may be about 32 µm to about 34 µm. Referring to FIG. 3B, a thickness of the conductive polymer layer 800 disposed on an upper surface of the cover panel 600 may be about 6.9 µm to about 8.7 µm.

Referring to FIG. 2 again, the set structure 30 may be disposed under the cover glass 700 and the cover panel 600. In a case where the thickness t1 of the conductive polymer layer 800 disposed on the lower surface of the cover glass 700 and the thickness t2 of the conductive polymer layer 800 disposed on the lower surface of the cover panel 600 are greater than about 50 µm, in case that the set structure 30 is attached to lower portions of the cover panel 600 and the cover glass 700, interference may occur, and changes in the set structure 30 may occur. In an embodiment, the thickness t1 of the conductive polymer layer 800 disposed on the lower surface of the cover glass 700 and the thickness t2 of the conductive polymer layer 800 disposed on the lower surface of the cover panel 600 may be about 50 µm or less, and thus, in case that the set structure 30 is attached onto the lower surface of the cover panel 600, interference and structural changes may be prevented from occurring due to the conductive polymer layer 800 in case that the set structure 30 is attached.

FIGS. 4 to 6 schematically show a method of manufacturing a display device. More specifically, FIGS. 4 to 6 schematically show a process of forming the conductive polymer layer 800.

Referring to FIG. 4, the material 800s for forming a conductive polymer layer may be disposed on the cover glass 700, the polarizing layer 500, the display panel 10, and the cover panel 600. The material 800s for forming a conductive polymer layer may include a conductive polymer 800a and a solvent 800b. The conductive polymer 800a may include poly(3,4-ethylenedioxythiophene) polystyrene sulfonate (PEDOT:PSS). The solvent 800b may include de-ionized water or alcohol that may be evaporated or naturally dried.

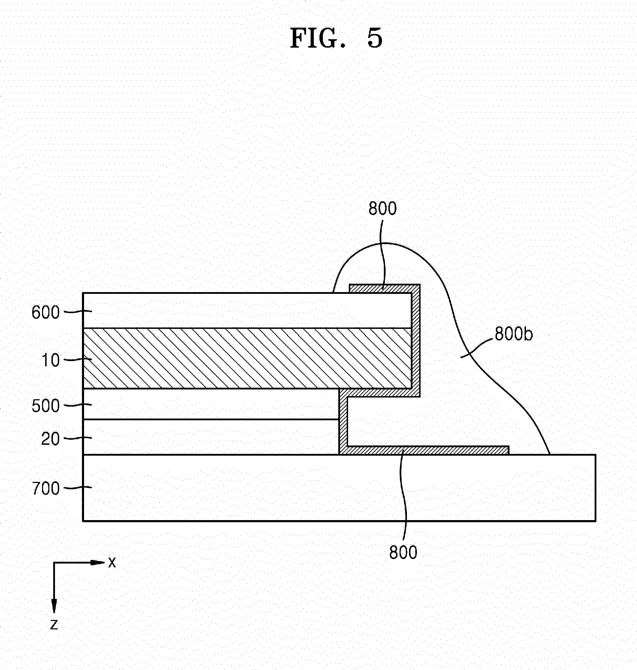

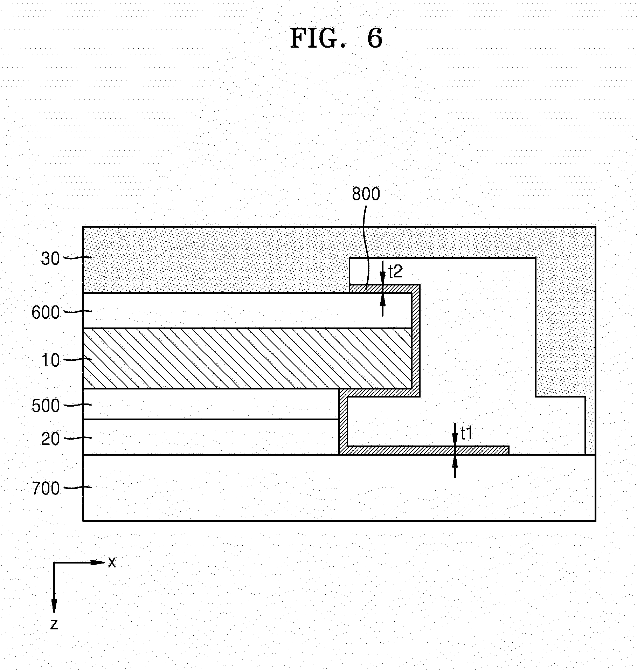

Referring to FIGS. 5 and 6, because the material 800s for forming a conductive polymer layer may include de-ionized water or alcohol, which is the solvent 800b that may evaporate, the conductive polymer layer 800 including the conductive polymer 800a may be formed by naturally drying the material 800s for forming a conductive polymer layer. The conductive polymer layer 800 may be continuously arranged along an upper surface of the cover glass 700, side surfaces of the polarizing layer 500 and the adhesive layer 20, lower and side surfaces of the display panel 10, and upper and side surfaces of the cover panel 600. FIG. 5 shows that the solvent 800b included in the material 800s for forming a conductive polymer layer may be reduced by partial evaporation, and FIG. 6 shows that the solvent 800b included in the material 800s for forming a conductive polymer layer may be completely removed through evaporation to form the conductive polymer layer 800 including the conductive polymer 800a.

A viscosity of the material 800s for forming a conductive polymer layer may be at least about 100 cP.s but not more than about 500 cP.s. In case that a viscosity of the material 800s for forming a conductive polymer layer is less than about 100 cP.s, spreadability of the material 800s for forming a conductive polymer layer may increase, and thus, even in case that a desired amount is applied, a length or thickness of the conductive polymer layer 800 may not be efficiently controlled. In reality, it is difficult to implement a viscosity of the material 800s for forming a conductive polymer layer to be greater than about 500 cP.s. A viscosity of the material 800s for forming a conductive polymer layer may be ensured to be at least about 100 cP.s but not more than about 500 cP.s, and thus, spreadability of the material 800s for forming a conductive polymer layer on the upper surfaces of the cover glass 700 and the cover panel 600 may be controlled, and the minimum length d1 (refer to FIG. 1) of the conductive polymer layer 800 disposed on at least a part of a side portion of the display device 1 may be about 20 mm or greater.

A surface tension of the material 800s for forming a conductive polymer layer may be at least about 25 mN/m but not more than about 35 mN/m. In case that a surface tension of the material 800s for forming a conductive polymer layer is less than about 25 mN/m, spreadability of the material 800s for forming a conductive polymer layer may increase, and thus, even in case that a desired amount is applied, a length or thickness of the conductive polymer layer 800 may not be efficiently controlled. In case that a surface tension of the material 800s for forming a conductive polymer layer is greater than about 35 mN/m, spreadability of the material 800s for forming a conductive polymer layer may decrease, and thus, the conductive polymer layer 800 may have an undesirable thickness, which may degrade reliability and quality of a display device.

A content of the conductive polymer 800a in the material 800s for forming a conductive polymer layer may be at least about 3 % but not more than about 20 %. Ini case that a content of the conductive polymer 800a in the material 800s for forming a conductive polymer layer is less than about 3 %, the content of the conductive polymer 800a may be small, and thus, it may be difficult to implement characteristics of the conductive polymer layer 800. In case that a content of the conductive polymer 800a in the material 800s for forming a conductive polymer layer is greater than about 20 %, a balance between materials may be disrupted, and thus, dispersibility of the material 800s for forming a conductive polymer layer or uniformity thereof when applied may not be secured.

The thickness t1 of the conductive polymer layer 800 disposed on the upper surface of the cover glass 700 and the thickness t2 of the conductive polymer layer 800 disposed on the upper surface of the cover panel 600 may be about 50 µm or less. Because a content of the conductive polymer 800a included in the material 800s for forming a conductive polymer layer may be ensured to be at least about 3 % but not more than about 20 %, the thickness t1 of the conductive polymer layer 800 disposed on the upper surface of the cover glass 700 and the thickness t2 of the conductive polymer layer 800 disposed on the upper surface of the cover panel 600 may be ensured to be about 50 µm or less, and robustness and reliability of the display device 1 may be improved. The thickness t1 of the conductive polymer layer 800 disposed on the upper surface of the cover glass 700 and the thickness t2 of the conductive polymer layer 800 disposed on the upper surface of the cover panel 600 may be about 50 µm or less, and thus, in case that the set structure 30 is attached onto the cover panel 600, interference and structural changes may be prevented from occurring due to the conductive polymer layer 800 in case that the set structure 30 is attached.

In an embodiment, because the material 800s for forming a conductive polymer layer may include the conductive polymer 800a and the solvent 800b that may be naturally dried, the conductive polymer layer 800 may be formed by evaporating the solvent 800b, and accordingly, a thickness of the conductive polymer layer 800 may be ensured to be about 50 µm or less, and thus, in case that the set structure 30 is attached to upper portions of the cover panel 600 and the cover glass 700, interference may be prevented from occurring, and defects in the set structure 30 may be prevented. Because a thickness of the conductive polymer layer 800 may be ensured to be about 50 µm or less, the conductive polymer layer 800 may be formed (for example, freely formed) even on a part of a side portion of the display device 1, where the set structure 30 is attached, and quality and reliability of the display device 1 may be improved.

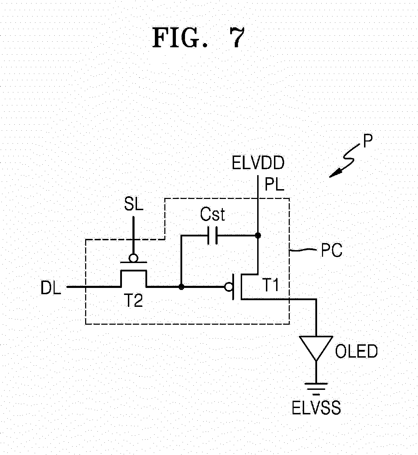

FIG. 7 is a schematic diagram of an equivalent circuit of a pixel P.

Referring to FIG. 7, a pixel circuit PC may include an organic light-emitting diode OLED as a display element connected to the pixel circuit PC as shown in FIG. 7. The pixel circuit PC may include a first thin-film transistor T1, a second thin-film transistor T2, and a storage capacitor Cst. Each pixel P may emit, for example, red, green, or blue light, or red, green, blue, or white light, through the organic light-emitting diode OLED.

The second thin-film transistor T2, which is a switching thin-film transistor, may be connected to a scan line SL and a data line DL, and may be configured to transfer a data voltage input from the data line DL to the first thin-film transistor T1, based on a switching voltage input from the scan line SL. The storage capacitor Cst may be connected to the second thin-film transistor T2 and a driving voltage line PL and may store a voltage corresponding to a difference between a voltage received from the second thin-film transistor T2 and a first power voltage ELVDD supplied to the driving voltage line PL.

The first thin-film transistor T1, which is a driving thin-film transistor, may be connected to the driving voltage line PL and the storage capacitor Cst, and may be configured to control a driving current flowing through the organic light-emitting diode OLED from the driving voltage line PL, in response to a voltage value stored in the storage capacitor Cst. The organic light-emitting diode OLED may emit light having certain brightness according to the driving current. An opposite electrode (e.g., a cathode) of the organic light-emitting diode OLED may receive a second power voltage ELVSS.

Although FIG. 7 shows the pixel circuit PC including two thin-film transistors and one storage capacitor, one or more embodiments are not limited thereto. The number of thin-film transistors and the number of storage capacitors may be variously modified according to the design of the pixel circuit PC. For example, the pixel circuit PC may further include four or five or more thin-film transistors in addition to the two thin-film transistors described above.

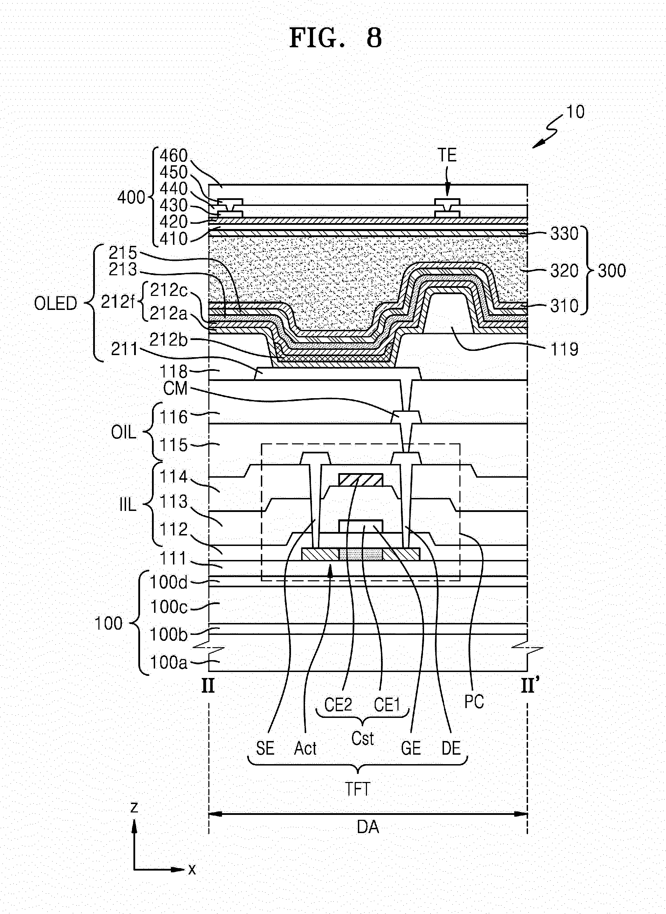

FIG. 8 is a schematic cross-sectional view of a display device. More specifically, FIG. 8 is a schematic cross-sectional view of the display device 1 shown in FIG. 1, taken along a line II-II' of FIG. 1.

Referring to FIG. 8, a substrate 100 may include a first base layer 100a, a first barrier layer 100b, a second base layer 100c, and a second barrier layer 100d. In an embodiment, the first base layer 100a, the first barrier layer 100b, the second base layer 100c, and the second barrier layer 100d may be sequentially stacked on one another in a thickness direction of a substrate 100.

At least one of the first base layer 100a and the second base layer 100c may include polymer resin, such as polyethersulfone, polyarylate, polyetherimide, polyethylene naphthalate, polyethylene terephthalate, polyphenylene sulfide, polyimide, polycarbonate, cellulose triacetate, or cellulose acetate propionate.

The first barrier layer 100b and the second barrier layer 100d are barrier layers that prevent intrusion of external foreign substances and may each have a single-layer or multi-layer structure including an inorganic material such as silicon nitride (SiNx), silicon oxide (SiO₂) and/or silicon oxynitride (SiON).

A buffer layer 111 may be disposed on the substrate 100. For example, the buffer layer 111 may include an inorganic insulating material such as silicon nitride (SiNx), silicon oxynitride (SiON) and silicon oxide (SiO₂), and may have a single-layer or multi-layer structure including the above-described inorganic insulating material.

An inorganic insulating layer IIL may be disposed on the buffer layer 111. The inorganic insulating layer IIL may include a first gate insulating layer 112, a second gate insulating layer 113, and an interlayer insulating layer 114.

The pixel circuit PC may be arranged in a display area DA. The pixel circuit PC may include a thin-film transistor TFT and the storage capacitor Cst. The thin-film transistor TFT may include a semiconductor layer Act, a gate electrode GE, a source electrode SE, and a drain electrode DE.

The semiconductor layer Act may be disposed on the buffer layer 111. The semiconductor layer Act may include polysilicon. As another example, the semiconductor layer Act may include amorphous silicon, an oxide semiconductor, or an organic semiconductor. The semiconductor layer Act may include a channel region, and a drain region and a source region respectively arranged on both sides of the channel region.

The gate electrode GE may be disposed over the semiconductor layer Act. The gate electrode GE may overlap the channel region. The gate electrode GE may include a low-resistance metal material. For example, the gate electrode GE may include a conductive material including molybdenum (Mo), aluminum (Al), copper (Cu), titanium (Ti), etc., and may have a multi-layer or single-layer structure including the above-described material.

The first gate insulating layer 112 may be disposed between the semiconductor layer Act and the gate electrode GE. The first gate insulating layer 112 may include an inorganic insulating material, such as silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), or zinc oxide (ZnO).

The second gate insulating layer 113 may be disposed on the gate electrode GE. The second gate insulating layer 113 may cover (or overlap) the gate electrode GE. The second gate insulating layer 113 may include an inorganic insulating material, such as silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), or zinc oxide (ZnO).

A second capacitor plate CE2 of the storage capacitor Cst may be disposed on the second gate insulating layer 113. The second capacitor plate CE2 may overlap the gate electrode GE disposed below. In this regard, the gate electrode GE and the second capacitor plate CE2 overlapping each other with the second gate insulating layer 113 therebetween may form or constitute the storage capacitor Cst. For example, the gate electrode GE may serve as a first capacitor plate CE1 of the storage capacitor Cst.

As described above, the storage capacitor Cst and the thin-film transistor TFT may overlap each other. However, one or more embodiments are not limited thereto. For example, the storage capacitor Cst may not overlap the thin-film transistor TFT. For example, the first capacitor plate CE1 of the storage capacitor Cst may be apart from the gate electrode GE of the thin-film transistor TFT as a separate element from the gate electrode GE of the thin-film transistor TFT.

For example, the second capacitor plate CE2 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W) and/or copper (Cu), and may have a single-layer or multi-layer structure including the above-described material.

The interlayer insulating layer 114 may be disposed on the second capacitor plate CE2. The interlayer insulating layer 114 may cover (or overlap) the second capacitor plate CE2. The interlayer insulating layer 114 may include silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), or zinc oxide (ZnO). The interlayer insulating layer 114 may have a single-layer or multi-layer structure including the above-described inorganic insulating material.

Each of the drain electrode DE and the source electrode SE may be on the interlayer insulating layer 114. Each of the drain electrode DE and the source electrode SE may be connected to the semiconductor layer Act through a contact hole defined in the first gate insulating layer 112, the second gate insulating layer 113, and the interlayer insulating layer 114. The drain electrode DE and the source electrode SE may include a highly conductive material. For example, the drain electrode DE and the source electrode SE may include a conductive material including molybdenum (Mo), aluminum (Al), copper (Cu), titanium (Ti), etc., and may have a multi-layer or single-layer structure including the above-described material. For example, the drain electrode DE and the source electrode SE may have a multi-layer structure of titanium (Ti)/aluminum (Al)/titanium (Ti).

An organic insulating layer OIL may be disposed on the inorganic insulating layer IIL. The organic insulating layer OIL may include a first organic insulating layer 115 and a second organic insulating layer 116. Although FIG. 8 shows the organic insulating layer OIL including two layers, one or more embodiments are not limited thereto. The organic insulating layer OIL may include three or four layers.

The first organic insulating layer 115 may cover the drain electrode DE and the source electrode SE. The first organic insulating layer 115 may include an organic insulating material such as a general commercial polymer, such as polymethylmethacrylate (PMMA) or polystyrene (PS), a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, and a blend thereof.

A connection electrode CM may be disposed on the first organic insulating layer 115. In this regard, the connection electrode CM may be connected to the drain electrode DE or the source electrode SE through a contact hole in the first organic insulating layer 115. The connection electrode CM may include a highly conductive material. The connection electrode CM may include a conductive material including molybdenum (Mo), aluminum (Al), copper (Cu), titanium (Ti), etc., and may have a multi-layer or single-layer structure including the above-described material. For example, the connection electrode CM may have a multi-layer structure of titanium (Ti)/aluminum (Al)/titanium (Ti).

The second organic insulating layer 116 may be disposed on the connection electrode CM. The second organic insulating layer 116 may cover the connection electrode CM. The second organic insulating layer 116 and the first organic insulating layer 115 may include a same material or different materials.

A light-emitting diode may be disposed on the second organic insulating layer 116. For example, the organic light-emitting diode OLED may be disposed on the second organic insulating layer 116. As another example, although not shown, an inorganic light-emitting diode may be disposed on the second organic insulating layer 116.

In an embodiment, the organic light-emitting diode OLED may emit red, green, or blue light, or may emit red, green, blue, or white light. The organic light-emitting diode OLED may include a first electrode 211, an emission layer 212b, a functional layer 212f, a second electrode 213, and a capping layer 215. The first electrode 211 may be a pixel electrode (e.g., an anode) of the organic light-emitting diode OLED, and the second electrode 213 may be an opposite electrode (e.g., a cathode) of the organic light-emitting diode OLED.

The first electrode 211 may be disposed on the second organic insulating layer 116. The first electrode 211 may be electrically connected to the connection electrode CM through a contact hole defined in the second organic insulating layer 116. The first electrode 211 may include conductive oxide, such as indium tin oxide (ITO), indium zinc oxide (IZO), zinc oxide (ZnO), indium oxide (In2O3), indium gallium oxide (IGO), or aluminum zinc oxide (AZO). In an embodiment, the first electrode 211 may include a reflection layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. In an embodiment, the first electrode 211 may further include a layer on/under the above-described reflection layer and formed of ITO, IZO, ZnO, or In2O3. For example, the first electrode 211 may have a multi-layer structure of ITO/Ag/ITO.

A pixel-defining layer 118 in which an opening exposing at least a portion of the first electrode 211 is defined may be disposed on the first electrode 211. An emission area of light emitted from the organic light-emitting diode OLED may be defined by the opening defined in the pixel-defining layer 118. For example, a width of the opening may correspond to a width of the emission area.

The pixel-defining layer 118 may include an organic insulating material. As another example, the pixel-defining layer 118 may include an inorganic insulating material, such as silicon nitride, silicon oxynitride, or silicon oxide. As yet another example, the pixel-defining layer 118 may include an organic insulating material and an inorganic insulating material. In an embodiment, the pixel-defining layer 118 may include a light-blocking material. The light-blocking material may include carbon black, carbon nanotubes, resin or paste including black dye, metal particles, for example, nickel, aluminum, molybdenum, and alloys thereof, metal oxide particles (e.g., chromium oxide), or metal nitride particles (e.g., chromium nitride). In case that the pixel-defining layer 118 includes a light-blocking material, the reflection of external light caused by metal structures disposed below the pixel-defining layer 118 may be reduced.

A spacer 119 may be disposed on the pixel-defining layer 118. The spacer 119 may include an organic insulating material, such as polyimide. As another example, the spacer 119 may include an inorganic insulating material such as silicon nitride (SiNx) or silicon oxide (SiO₂), or may include an organic insulating material and an inorganic insulating material.

In an embodiment, the spacer 119 and the pixel-defining layer 118may include a same material. In this case, the pixel-defining layer 118 and the spacer 119 may be formed together during a mask process using a halftone mask or the like. As another example, the spacer 119 and the pixel-defining layer 118 may include different materials, respectively.

The emission layer 212b may be arranged in the opening of the pixel-defining layer 118. The emission layer 212b may include a high-molecular weight or low-molecular weight organic material emitting light of a certain color.

The functional layer 212f may include a first functional layer 212a and a second functional layer 212c. The first functional layer 212a may be disposed between the first electrode 211 and the emission layer 212b, and the second functional layer 212c may be disposed between the emission layer 212b and the second electrode 213. However, at least one of the first functional layer 212a or the second functional layer 212c may be omitted. Hereinafter, a case where each of the first functional layer 212a and the second functional layer 212c is arranged will be mainly described.

The first functional layer 212a may include a hole transport layer (HTL) and/or a hole injection layer (HIL). The second functional layer 212c may include an electron transport layer (ETL) and/or an electron injection layer (EIL). The first functional layer 212a and/or the second functional layer 212c may be common layers that entirely cover the substrate 100 as the second electrode 213 described below does.

The second electrode 213 may be disposed on the functional layer 212f. The second electrode 213 may include a conductive material having a low work function. For example, the second electrode 213 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. As another example, the second electrode 213 may further include a layer, such as ITO, IZO, ZnO, or In2O3, on a (semi)transparent layer including the above-described material.

In an embodiment, the capping layer 215 may be disposed on the second electrode 213. The capping layer 215 may include lithium fluoride (LiF), an inorganic material and/or an organic material.

An encapsulation layer 300 may be disposed on the organic light-emitting diode OLED. The encapsulation layer 300 may cover (or overlap) the organic light-emitting diode OLED. The encapsulation layer 300 may be disposed on the second electrode 213 and/or the capping layer 215. In an embodiment, the encapsulation layer 300 may include at least one inorganic encapsulation layer and at least one organic encapsulation layer. FIG. 8 shows the encapsulation layer 300 including a first inorganic encapsulation layer 310, an organic encapsulation layer 320, and a second inorganic encapsulation layer 330 which are sequentially stacked on one another.

In an embodiment, the first inorganic encapsulation layer 310 and the second inorganic encapsulation layer 330 may include one or more inorganic materials among aluminum oxide, titanium oxide, tantalum oxide, hafnium oxide, zinc oxide, silicon oxide, silicon nitride, and silicon oxynitride. The first inorganic encapsulation layer 310 and the second inorganic encapsulation layer 330 may have a single-layer or multi-layer structure including the above-described material. The organic encapsulation layer 320 may include a polymer-based material. Examples of the polymer-based material may include acryl-based resin, epoxy-based resin, polyimide, and polyethylene. In an embodiment, the organic encapsulation layer 320 may include acrylate.

An input sensing layer 400 may be disposed on the encapsulation layer 300. The input sensing layer 400 may include a first touch insulating layer 410, a second touch insulating layer 420, a first conductive layer 430, a third touch insulating layer 440, a second conductive layer 450, and/or a planarization layer 460.

In an embodiment, the first touch insulating layer 410 may be disposed on the second inorganic encapsulation layer 330, and the second touch insulating layer 420 may be disposed on the first touch insulating layer 410. In an embodiment, the first touch insulating layer 410 and the second touch insulating layer 420 may include an inorganic insulating material and/or an organic insulating material. For example, the first touch insulating layer 410 and the second touch insulating layer 420 may include an inorganic insulating material such as silicon oxide, silicon nitride and/or silicon oxynitride.

In an embodiment, at least one of the first touch insulating layer 410 and the second touch insulating layer 420 may be omitted. For example, the first touch insulating layer 410 may be omitted. In this case, the second touch insulating layer 420 may be disposed on the second inorganic encapsulation layer 330, and the first conductive layer 430 may be disposed on the second touch insulating layer 420.

The first conductive layer 430 may be disposed on the second touch insulating layer 420, and the third touch insulating layer 440 may be disposed on the first conductive layer 430. In an embodiment, the third touch insulating layer 440 may include an inorganic insulating material and/or an organic insulating material. For example, the third touch insulating layer 440 may include an inorganic insulating material such as silicon oxide, silicon nitride and/or silicon oxynitride.

The second conductive layer 450 may be disposed on the third touch insulating layer 440. A touch electrode TE of the input sensing layer 400 may have a structure in which the first conductive layer 430 and the second conductive layer 450 are connected to each other. As another example, the touch electrode TE may be formed in one of the first conductive layer 430 and the second conductive layer 450 and may include a metal line included in the corresponding conductive layer. Each of the first conductive layer 430 and the second conductive layer 450 may include at least one of aluminum (Al), copper (Cu), titanium (Ti), molybdenum (Mo), and indium tin oxide (ITO), and may have a single-layer or multi-layer structure including the above-described material. For example, each of the first conductive layer 430 and the second conductive layer 450 may have a three-layer structure of a titanium layer/an aluminum layer/a titanium layer.

In an embodiment, the planarization layer 460 may cover the second conductive layer 450. The planarization layer 460 may include an organic insulating material.

The above description is an example of technical features of the disclosure, and those skilled in the art to which the disclosure pertains will be able to make various modifications and variations. Thus, the embodiments of the disclosure described above may be implemented separately or in combination with each other.

The . The protection scope of the disclosure should be interpreted by the following claims.

## Claims

1. A display device (1) comprising:
a cover panel (600);
a display panel (10) arranged on the cover panel (600);
a polarizing layer (500) arranged on the display panel (10);
a cover glass (700) arranged on the polarizing layer; and
a conductive layer (800) arranged along a lower surface of the cover glass (700), a side surface of the polarizing layer (500), upper and side surfaces of the display panel (10), and lower and side surfaces of the cover panel (600),
wherein a thickness of the conductive layer arranged on the lower surface of the cover panel (600) is 50 µm or less.

2. The display device (1) of claim 1, wherein an end of the cover glass (700), an end of the polarizing layer (500), and an end of the display panel (10) and of the cover panel (600) are not aligned with one another.

3. The display device (1) of claim 1 or 2, wherein a thickness of the conductive layer (800) arranged on the lower surface of the cover glass (700) is 50 µm or less, and/or wherein a minimum length of the conductive layer (800) arranged on at least a part of a side portion of the display device (1) is 20 mm or greater.

4. The display device (1) of any of the preceding claims, wherein the conductive layer (800) comprises poly(3,4-ethylenedioxythiophene) polystyrene sulfonate, PEDOT:PSS.

5. The display device (1) of any of the preceding claims, further comprising:
an adhesive layer (20) arranged between the polarizing layer (500) and the cover glass (700).

6. The display device (1) of claim 5, wherein the conductive layer (800) is further arranged on a side surface of the adhesive layer (20).

7. The display device (1) of any of the preceding claims, further comprising:
a set structure (30) arranged under the cover glass (700) and the cover panel (600).

8. A method of manufacturing a display device (1) of any of the preceding claims, the method comprising:
arranging a material (800s) for forming a conductive polymer layer (800) on a cover glass (700), a polarizing layer, a display panel (10), and a cover panel (600); and
forming a conductive polymer layer (800) by naturally drying the material (800s) for forming a conductive polymer layer (800).

9. The method of claim 8, wherein the conductive polymer layer (800) is arranged along a lower surface of the cover glass (700), a side surface of the polarizing layer, upper and side surfaces of the display panel (10), and lower and side surfaces of the cover panel (600), and/or wherein the material (800s) for forming a conductive polymer layer (800) comprises a conductive polymer (800a) and a solvent (800b).

10. The method of claim 9, wherein, when the material (800s) for forming a conductive polymer layer (800) is dried, the solvent (800b) comprised in the material (800s) for forming a conductive polymer layer (800) evaporates to form the conductive polymer layer (800).

11. The method of claim 9 or 10, wherein the conductive polymer (800a) comprises poly(3,4-ethylenedioxythiophene) polystyrene sulfonate, PEDOT:PSS, and/or wherein the solvent (800b) comprises de-ionized water or alcohol.

12. The method of any of claims 9 to 11, wherein a viscosity of the material (800s) for forming a conductive polymer layer (800) is at least 100 cP.s but not more than 500 cP.s, and/or wherein a content of the conductive polymer (800a) in the material (800s) for forming a conductive polymer layer (800) is at least 3 % but not more than 20 %.

13. The method of any of claims 8 to 12, wherein a thickness of the conductive polymer layer (800) arranged on an lower surface of the cover panel (600) is 0 µm or less, and/or

14. The method of any of claims 8 to 13, wherein a minimum length of the conductive polymer layer (800) arranged on at least a part of a side portion of the display device (1) is 20 mm or greater, and/or further comprising:
arranging a set structure (30) under the cover panel (600) and the cover glass (700).

15. The method of any of claims 9 to 14, wherein a surface tension of the material (800s) for forming a conductive polymer layer (800) is at least 25 mN/m but not more than 35 mN/m.
